# DEMANDE DE BREVET EUROPEEN

(11) **EP 2 339 658 A2**
(43) Date de publication de la demande: **29.06.2011**
(21) Numéro de dépôt: 10196284.3
(22) Date de dépôt: 21.12.2010
(51) Int. Cl.: H01L 51/00, H01L 51/52

(54) **Procédé de fabrication d'une électrode a nanostructures métallique et diélectrique pour le filtrage coloré dans une OLED et procédé de fabrication d'une OLED**

(30) Priorité: 23.12.2009 FR 0959499
(71) Demandeur: Commissariat à l'Énergie Atomique et aux Énergies Alternatives, 75015 Paris (FR)
(72) Inventeur: Landis, Stefan, 38500 Voiron (FR); Chaix, Nicolas, 38410 Saint-Martin D'Uriage (FR); Ivanova-Hristova, Valentina, 38000 Grenoble (FR); Pernel, Carole, 38120 Saint-Egreve (FR)
(74) Mandataire: Augarde, Eric

(57) **Abrégé**

Procédé de fabrication d'une électrode pour une diode électroluminescente organique OLED, ladite électrode comprenant une surface comprenant une première nanostructuration diélectrique et une seconde nanostructuration métallique, sur un substrat (61), dans lequel on réalise les étapes successives suivantes :
a) on dépose une couche métallique (63), sur une surface plane (62) d'un substrat (61) ;
b) on prépare sur la couche métallique (63) une couche diélectrique (65) comprenant ladite première nanostructuration diélectrique (66) qui comporte des cavités (67) qui s'étendent depuis la surface supérieure (68) de la couche diélectrique (65) jusqu'à la surface supérieure (64) de la couche métallique (63) ;
c) on remplit au moins partiellement les cavités (67) de la première nanostructuration diélectrique (66) par un métal (611), moyennant quoi, on obtient la deuxième nanostructuration métallique.
Procédé de fabrication d'une OLED présentant un filtrage coloré et un renforcement de l'extraction lumineuse, comprenant ladite électrode.

## Description

### DOMAINE TECHNIQUE

L'invention concerne un procédé de fabrication d'une électrode, de préférence d'une anode, comprenant une surface avec des nanostructures métalliques et diélectriques pour le filtrage coloré et le renforcement de l'extraction lumineuse dans une diode électroluminescente organique (« OLED » ou « Organic Light Emitting Diode » en anglais).

L'invention concerne, en outre, un procédé de fabrication d'une diode électroluminescente organique OLED comprenant au moins une étape de fabrication d'une électrode comprenant une surface avec des nanostructures métalliques et diélectriques par le procédé ci-dessus.

Le domaine technique de l'invention peut être défini comme celui des diodes électroluminescentes organiques et plus particulièrement comme celui des diodes électroluminescentes organiques dont une électrode, de préférence l'anode, est pourvue de nanostructurations métalliques en vue d'un filtrage coloré et du renforcement de l'extraction lumineuse.

### ÉTAT DE LA TECHNIQUE ANTÉRIEURE

Les diodes électroluminescentes organiques OLED sont des diodes de nouvelle génération et constituent une technologie très prometteuse pour les afficheurs, tels que les écrans de télévisions et les écrans d'ordinateurs etc., et pour l'éclairage, grâce à leur faible consommation électrique.

De manière simplifiée, une diode électroluminescente organique comprend un substrat ou superstrat, une anode, une cathode et une ou des couche(s) organique(s) émettrice(s) prévue(s) entre l'anode et la cathode.

L'électrode en contact avec le substrat est généralement l'anode.

L'émission de lumière peut se faire du côté de l'anode ou bien du côté de la cathode.

L'électrode au travers de laquelle est réalisée l'émission de lumière est transparente à cette lumière.

Une OLED typique, dans laquelle l'émission de lumière est réalisée du côté de l'anode et du substrat comprend ainsi par exemple un substrat (que l'on peut alors appeler superstrat) de verre, une anode transparente par exemple en oxyde d'indium et d'étain (« ITO » ou « Indium Tin Oxide » en anglais), un empilement de couches organiques, et un miroir métallique faisant office de cathode.

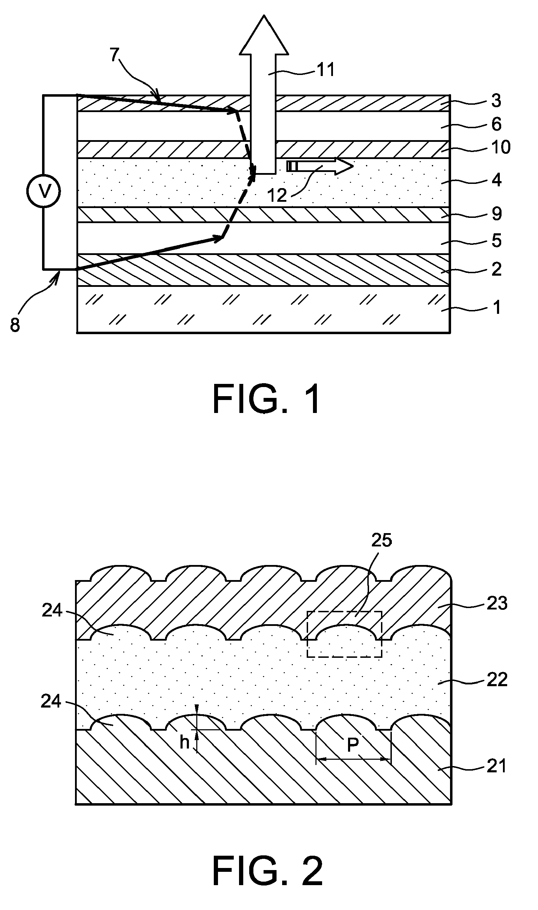

Sur la figure 1, on a représenté une autre OLED typique, dans laquelle l'émission de lumière est réalisée du côté de la cathode (3), à savoir du côté opposé à l'anode (2) et au substrat (1).

Cette diode comprend une ou plusieurs couche(s) mince(s) organique(s) émettrice(s) (4), par exemple trois couches minces organiques émettrices qui émettent respectivement dans le rouge, le vert et le bleu, qui sont entourées d'une part par une anode métallique (2) par exemple en aluminium ou en argent en contact avec le substrat (1) et d'autre part par une cathode transparente (3) constituée par exemple par de l'ITO ou par une couche mince d'argent.

Des couches diélectriques (5, 6) dopées P (5) ou N (6) aussi appelées couches d'injections d'électrons ou de trous sont généralement ajoutées entre les électrodes (2, 3) et les couches émettrices (4) afin d'améliorer l'injection des charges (électrons (7) et trous (8)) dans les couches émettrices organiques (4). Des couches de blocage d'électrons (9) et de blocage de trous (10) peuvent également être prévues.

Dans une OLED et notamment dans une OLED telle que celle représentée sur la figure 1, la lumière est émise dans les couches organiques dans toutes les directions.

Seulement une fraction des photons émis (20% environ) est réellement extraite de la diode (11) et 80% des photons et de la lumière sont donc perdus (12) dans les différents modes électromagnétiques relatifs aux couches métalliques et diélectriques.

Ces photons perdus, capturés par la structure sont éventuellement absorbés par effet Joule ou réémis sur les bords de la diode. Dans tous les cas, ces photons ne participent pas à la « lumière utile » de la diode.

Il est donc crucial d'améliorer l'extraction des photons perdus afin de les convertir en photons utiles pour augmenter le rendement optique.

Pour récupérer une partie de l'énergie perdue dans les plasmons ou les modes guidés, l'utilisation de réseaux périodiques a été proposée par exemple dans le document de W.L. BARNES, Journal of Lightwave technology, Vol. 17, No. 11, novembre 1999, pages 2170 - 2182 [1].

Ces réseaux peuvent être à une dimension, tels que des réseaux de lignes sensibles à une polarisation des émetteurs, ou à deux dimensions, tels que des réseaux carrés, triangulaires, des réseaux d'Archimède, ou des réseaux à géométrie plus complexe.

Sur la figure 2, on a représenté de manière simplifiée une OLED avec une anode (21), des couches organiques (22) et une cathode (23) qui sont pourvues de structurations périodiques (24) constituées par des motifs (25). Ces structurations périodiques ont une période P et une hauteur h.

Toutefois, une structuration mal maîtrisée peut entraîner une mise en court-circuit des deux électrodes, rendant l'empilement OLED inutilisable. De plus, la technologie permettant la structuration de l'OLED doit être nécessairement compatible avec les procédés de fabrication utilisés en microélectronique.

Les couches organiques émettrices des OLED sont en outre très sensibles à l'air, à l'eau, et aux contraintes mécaniques.

L'expérience montre que les molécules émettrices de ces couches supportent mal tous les traitements intervenant « a posteriori » après la réalisation globale de la diode. C'est pourquoi la structuration de l'OLED est avantageusement imprimée, réalisée directement sur le substrat comme cela est décrit dans le document de D.K. GILFORD et D.G. HALL, Applied Physics Letters, Volume 81, Number 23, 2 décembre 2002, pages 4315 - 4317 [2] et dans le document de D.K. GILFORD et D.G. HALL, Applied Physics Letters, Volume 80, Number 20, 20 mai 2002, pages 3679 - 3681 [3]. Les dépôts de différentes couches métalliques et organiques de la diode étant conformant, le motif du réseau est reproduit sur l'ensemble de la diode.

Plus précisément, le document de D.K. GILFORD et D.G. HALL, Applied physics Letters, Volume 81, Number 23, 2 décembre 2002, pages 4315 - 4317 [2], décrit la fabrication d'une OLED au cours de laquelle on dépose tout d'abord par centrifugation une couche de résine photosensible d'une épaisseur de 80 mm sur un substrat en silicium.

Cette couche de résine photosensible est ensuite impressionnée holographiquement et traitée pour former un réseau présentant un relief de surface avec une période de 550 nm et une amplitude pic-vallée d'environ 60 nm.

Sur la couche de résine photosensible, on dépose successivement cinq couches par dépôt sous vide, à savoir une couche d'or, une couche de « NPB », une couche de tris (8-hydroquinoline) aluminium (Alq₃), une couche d'aluminium et une couche d'argent. La couche d'or forme l'anode du dispositif tandis que les couches d'Al/Ag forment la cathode.

Les couches déposées sur la résine, reproduisent le réseau sous-jacent de celle-ci, formant ainsi une ondulation périodique dans l'ensemble de la structure.

Dans le document de D.K. GILFORD et D.G. HALL, Applied Physics Letters, Volume 80, Number 20, 20 mai 2002, pages 3679 - 3681 [3], des lames de verre sont tout d'abord revêtues avec une couche mince (200 nm) de résine photosensible.

Les films de résine photosensible sont ensuite exposés à des franges d'interférences holographiques et révélés pour former un réseau présentant un relief de surface avec des périodes de 535 à 610 nm et des amplitudes pics-vallées d'environ 100 nm.

Les échantillons sont ensuite revêtus sous vide avec un film de tris(8-hydroquinoline) aluminium (Alq₃) d'une épaisseur de 200 nm, puis avec une couche d'argent d'une épaisseur de 50 nm.

Les couches déposées reproduisent le profil de la surface sous-jacente en résine et forment ainsi des ondulations dans l'ensemble de la structure.

Par ailleurs, le document de K. ISHIHARA, Applied Physics Letters 90, 111114 (2007) [4] décrit la fabrication d'une OLED avec une couche de cristaux photoniques bidimensionnels. Une ondulation périodique bidimensionnelle, à savoir un motif de treillis carré est formé sur un substrat en verre par une technique de lithographie par nano-impression directe (« direct NIL »).

Plus exactement, on commence par fabriquer un moule en silicium avec un motif en treillis carré de plots circulaires. Ce moule est placé dans une machine de lithographie par nano-impression et un substrat en verre est également placé sur le moule. On chauffe ensuite sous vide à une température supérieure à la température de transition vitreuse du substrat. Puis le motif de la couche de cristaux photoniques sur le moule est estampé sur la surface en verre par le piston de la machine de lithographie par nano-impression, et le substrat en verre est séparé du moule par refroidissement.

Sur le substrat en verre est déposée une anode transparente en Oxyde de Zinc et d'Indium (IZO) par pulvérisation cathodique, puis les autres couches de l'OLED sont formées par évaporation sous vide.

Le document US-B1-6,670,772 [5] a trait à la préparation d'un écran à OLED qui comprend un substrat, une couche de transistors à couches minces (« TFT ») formée sur le substrat, une couche isolante formée sur la couche de « TFT » et définissant une structure de réseau périodique, une première couche d'électrode formée sur la structure de réseau et conforme à la structure de réseau, une couche de matériau « OLED » formée sur la première couche d'électrode et conforme à la structure de réseau, et une seconde couche d'électrode formée sur la couche de matériau OLED et conforme à la structure de réseau.

Le document US-A1-2005/0088084 [6] décrit un dispositif sensiblement analogue à celui du document [5].

Le document US-A1-2001/0038102 [7] décrit un dispositif pour émettre de la lumière, telle qu'une OLED, qui comprend un substrat comportant deux éléments, à savoir une base transparente et une résine photopolymérisable.

La résine photopolymérisable est appliquée sur la surface supérieure de la base transparente.

Un moule d'estampage muni d'ondulations, nervures, permet de former une structuration dans la couche de résine.

Puis, on dépose successivement une première couche d'électrode, une couche active et une seconde couche d'électrode sur la couche de résine structurée.

Une structuration globale de la diode, telle que celle réalisée dans les documents précédemment cités permet le repliement des relations de dispersion des modes de plasmons de surface associées à toutes les interfaces métal-diélectriques comme cela est mentionné dans les documents [4] et [5]. Ces modes, évanescents par nature, deviennent radiatifs, entraînant un renforcement de l'extraction de lumière qui est indiqué dans les documents [4] à [7].

Si l'on s'intéresse maintenant aux procédés pour la réalisation d'un substrat nanostructuré, on note parmi les procédés mentionnés dans la littérature la nano-impression (« nano-imprint ») qui est notamment décrite dans les documents [4] et [7].

Cette technique de fabrication d'un substrat nanostructuré est compatible avec les procédés de fabrication utilisés en micro-électronique.

Cette technique permet également une production massive lorsque les processus sont bien maîtrisés.

Cependant, comme cela est précisé dans l'article [4] et le brevet [7], la forme du motif constituant la structure est directement liée au moule utilisé et plusieurs moules sont donc nécessaires pour la réalisation de motifs différents et pour fabriquer une surface nanostructurée complexe.

En outre, aussi bien dans le cas de la technique de nano-impression que dans le cas des autres techniques de préparation de substrats à surfaces nanostructurées, le contrôle de la forme du motif est crucial, et peut s'avérer critique, car cette forme a des répercussions sur toutes les couches ensuite déposées de manière conforme sur cette surface et donc sur le fonctionnement de l'ensemble du dispositif finalement fabriqué sur ce substrat tel qu'une OLED.

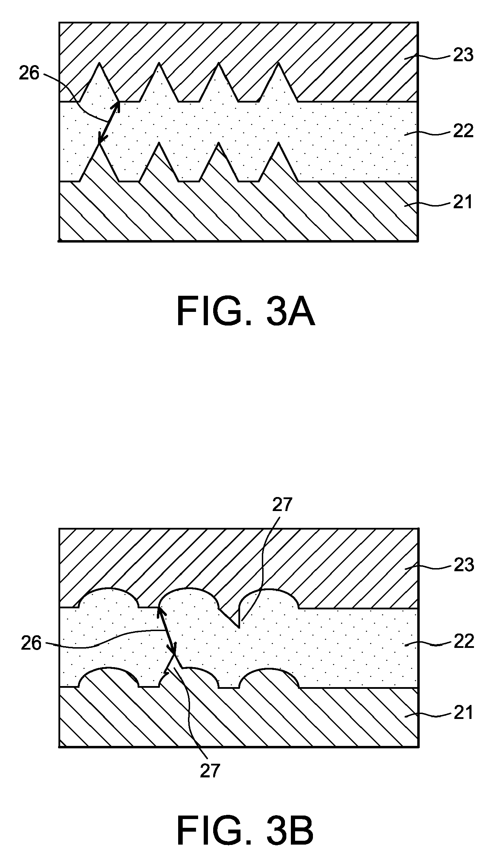

En effet, si un motif présente des arrêtes ou des pentes trop brutales, comme cela est représenté sur la figure 3A, des phénomènes de courts-circuits (26) entre les deux électrodes (21, 23) peuvent se produire, rendant l'OLED inutilisable.

De plus (voir figure 3B), comme tous les procédés de fabrication de substrats à surfaces nanostructurées, la nano-impression peut également donner localement des motifs avec des défauts (27) tels que pointes, aspérités, bosses, ou une rugosité importante. La présence de ces défauts (27) locaux favorise l'apparition de courts-circuits (26).

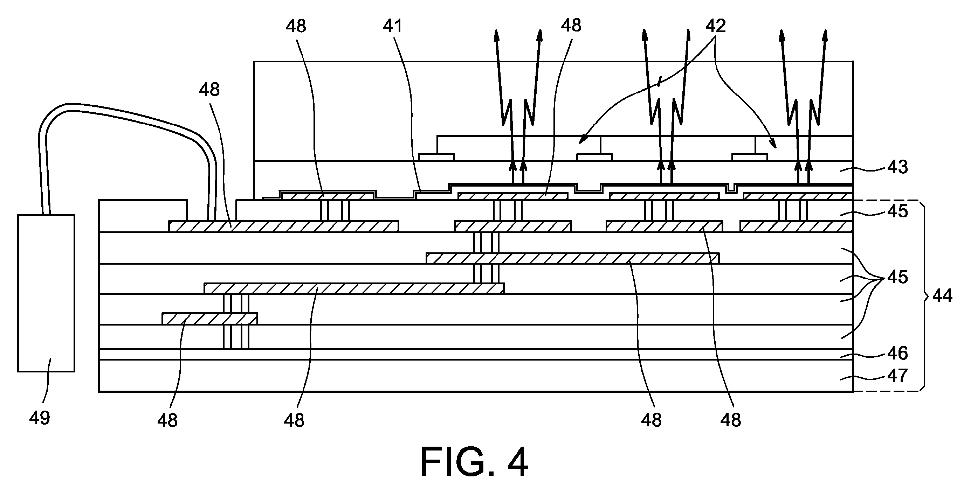

Par ailleurs, en ce qui concerne le filtrage coloré, la solution actuellement utilisée, qui est représentée sur la Figure 4, consiste à disposer au-dessus de l'élément OLED (41), des filtres colorés (42) qui sont collés par l'intermédiaire d'une couche de colle (43) sur la cathode de l'OLED. L'OLED est déposée sur un circuit de commande (« IC ») (44) qui permet de piloter indépendamment chaque pixel. Le circuit de commande comprend des couches d'isolant (45), une couche de transistors (46), un substrat (47), et des connexions métalliques (48) ainsi qu'un système électronique (49). Cette solution diminue encore plus la quantité de lumière émise.

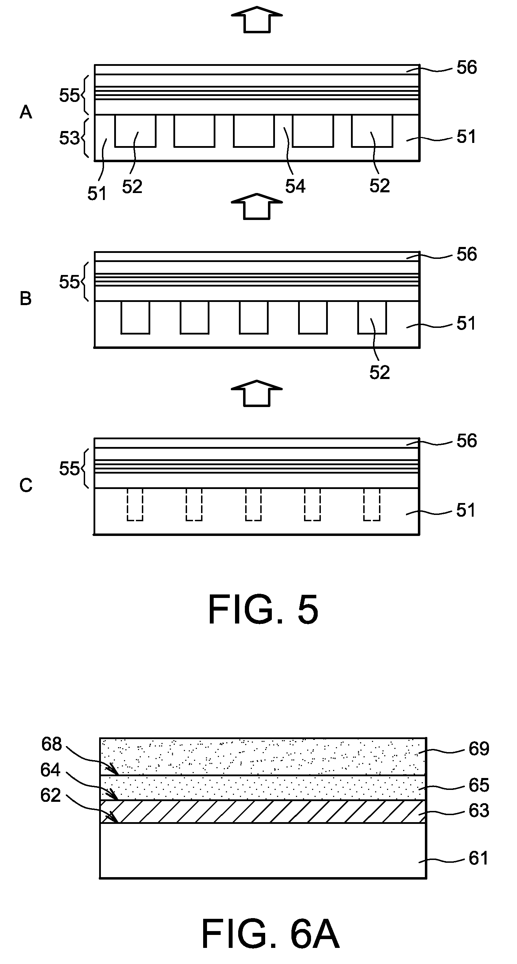

Une autre solution consiste à réaliser des réseaux métal-diélectriques avec des lignes métalliques et des lignes diélectriques, comme cela est représenté sur la figure 5, pour jouer sur l'indice optique effectif du matériau de façon à réaliser un filtrage coloré. La modification de la largeur de la ligne métallique et de la ligne diélectrique permet de choisir la couleur qui sera extraite de l'OLED.

Plus précisément, on réalise (Fig. 5A) une lithographie et une étape de gravure dans une couche métallique (51), puis un dépôt de diélectrique (52) (Fig. 5B) et une étape de polissage mécano-chimique (« CMP »), et l'on obtient ainsi une anode (53) avec des motifs (54) dont les dimensions caractéristiques sont de l'ordre de la centaine de nanomètres. On dépose ensuite sur l'anode les couches diélectriques et les couches organiques émettrices de l'OLED (55) qui émettent dans le blanc et enfin la couche de cathode semi-transparente (56).
La principale difficulté de cette solution provient de l'étape de « CMP » qui est difficile à mettre en oeuvre, surtout dans le cas de densités de motifs à polir différentes. En effet, pour des densités de motifs différentes, les vitesses de polissage sont différentes et il faut donc ajouter des motifs fictifs pour homogénéiser les vitesses de polissage. Cela entraîne une perte d'espace fonctionnel pour l'émission de lumière. Il est alors difficile de réaliser côte à côte des pixels avec un filtrage coloré différent.

Il existe donc au vu de ce qui précède, un besoin pour un procédé de fabrication d'une électrode, telle qu'une anode, comprenant une nanostructuration métal/diélectrique sur un substrat, pour une diode électroluminescente organique OLED, qui permette de préparer de manière simple, fiable, reproductible et en un nombre limité d'étapes, une telle électrode, telle qu'une anode, nanostructurée quels que soient le type, la forme et la complexité de cette nanostructuration et des motifs qui peuvent la composer.

Il existe, en outre, un besoin pour un tel procédé qui permette de maîtriser, contrôler parfaitement, très précisément, la nanostructuration, et notamment la forme des motifs qui peuvent composer celle-ci.

Il existe encore un besoin pour un tel procédé qui permette d'obtenir un filtrage coloré tout en évitant l'étape de gravure dans un métal, l'étape de dépôt d'un diélectrique/remplissage par un diélectrique, et surtout l'étape de polissage mécano-chimique, avec toutes les difficultés qu'elle occasionne.

Ce procédé doit, enfin, être totalement compatible avec les procédés de fabrication mis en oeuvre dans la micro-électronique et notamment avec les différents procédés utilisés dans la fabrication des OLEDs.

En d'autres termes, il existe un besoin pour un procédé de fabrication d'une électrode telle qu'une anode comprenant une nanostructuration métal/diélectrique sur un substrat, pour une diode électroluminescente organique OLED, qui assure, entre autres, un renforcement de l'extraction de la lumière de l'OLED, un filtrage coloré sans diminution de la lumière émise, une connexion de l'OLED de préférence par la surface de l'anode, un adressage électrique individuel de chaque pixel, et qui permette de réaliser côte à côte des pixels avec un filtrage coloré différent.

Le but de la présente invention est de fournir un procédé de fabrication d'une électrode, telle qu'une anode, comprenant une nanostructuration métal/diélectrique, sur un substrat, pour une diode électroluminescente organique OLED, qui réponde entre autres aux besoins et exigences énumérés plus haut.

Le but de la présente invention est aussi de fournir un procédé de fabrication d'une anode comprenant une nanostructuration métal/diélectrique, sur un substrat, pour une diode électroluminescente organique OLED, qui ne présente pas les inconvénients, défauts, limitations et désavantages des procédés de l'art antérieur, et qui résolve les problèmes des procédés de l'art antérieur.

### EXPOSÉ DE L'INVENTION

Ce but, et d'autres encore, sont atteints, conformément à l'invention par un procédé de fabrication d'une électrode pour une diode électroluminescente organique OLED, comprenant une surface comprenant une première nanostructuration diélectrique et une seconde nanostructuration métallique, sur un substrat, dans lequel on réalise les étapes successives suivantes:
a) on dépose une couche métallique, sur une surface plane d'un substrat ;
b) on prépare sur la couche métallique une couche diélectrique comprenant ladite première nanostructuration diélectrique qui comporte des cavités qui s'étendent depuis la surface supérieure de la couche diélectrique jusqu'à la surface supérieure de la couche métallique;
c) on remplit au moins partiellement les cavités de la première nanostructuration diélectrique par un métal, moyennant quoi on obtient la deuxième nanostructuration métallique.

Selon un premier mode de réalisation, lors de l'étape b), la couche diélectrique comprenant la première nanostructuration peut être préparée en déposant une couche en un matériau diélectrique puis une couche de résine sur la couche métallique, en procédant à la lithographie de la couche de résine pour éliminer la résine dans des zones correspondant aux cavités à définir dans la couche diélectrique, en gravant la couche en un matériau diélectrique pour définir les cavités, et en retirant la résine.

Avantageusement, la lithographie de la couche de résine peut être réalisée par un procédé choisi parmi la lithographie optique, la lithographie électronique, la lithographie de nanoimpression assistée par UV, et la lithographie par nanoimpression thermique.

Avantageusement, dans ce premier mode de réalisation, le matériau diélectrique peut être choisi parmi SiO₂, HfO₂ et tous les matériaux isolants électriquement.

Avantageusement, dans ce premier mode de réalisation, la résine peut être choisie parmi les résines thermoplastiques et les résines thermodurcissables telles que les poly(styrène)s (PS), les poly(méthacrylate de méthyle)s (PMMA)s, les polyesters insaturés, les résines époxydes, les résines phénoliques, les polyimides, les polyamides, les polycarbonates, les polyoléfines tels que les polypropylènes, le POSS ou « polyhedral oligomeric silsesquioxane » et les mélanges de celles-ci.

Selon un second mode de réalisation, lors de l'étape b) la couche diélectrique comprenant la première nanostructuration peut être préparée en déposant une couche en une résine diélectrique, ou une couche en une résine ou en un matériau, ladite résine ou ledit matériau étant susceptible d'être transformé(e) en un matériau diélectrique, sur la couche métallique, en procédant à la lithographie de la couche en une résine ou en un matériau, susceptible d'être transformé(e) en un matériau diélectrique pour y définir les cavités, et en transformant la résine ou le matériau susceptible d'être transformé(e) en un matériau diélectrique par un traitement thermique.

Dans ce second mode de réalisation, c'est le traitement thermique qui transforme la résine ou le matériau en un matériau diélectrique.

Avantageusement, dans ce second mode de réalisation, la couche diélectrique peut être en un matériau diélectrique choisi parmi les matériaux appelés « spin on glass » ou verres centrifugés préparés à partir de matériaux précurseurs (c'est-à-dire de matériaux susceptibles d'être transformés en un matériau diélectrique) tels que le Hydrogèno SilsesQuioxane (HSQ); ou les Polyhedral Oligomeric SilSesquioxanes (POSS).

Dans ce second mode de réalisation, on peut considérer que l'on dépose par exemple une résine qui, après traitement, sera proche du verre ou du SiO₂ de part sa composition et ses propriétés.

Avantageusement, dans ce second mode de réalisation, la lithographie de la couche en une résine ou en un matériau susceptible d'être transformé(e) en un matériau diélectrique peut être réalisée par un procédé choisi parmi la lithographie optique, la lithographie électronique, la lithographie de nanoimpression assistée par UV, et la lithographie de nanoimpression thermique.

Avantageusement, le substrat peut être en un matériau choisi parmi le verre, les céramiques transparentes, et les plastiques transparents.

Avantageusement, la couche métallique peut être en un métal choisi parmi le platine, le cobalt, le nickel, le fer, l'argent, l'aluminium, l'iridium, l'or, le molybdène, le palladium ; et leurs alliages.

Avantageusement, l'étape c) peut être réalisée par un procédé électrochimique choisi parmi les procédés d'électro-déposition à potentiel ou à courant imposé et les procédés d'électro-réduction sans courant appelés procédés « electroless ».

Avantageusement, on peut remplir les cavités de la première nanostructuration de la couche diélectrique, par un métal au moins jusqu'à la surface supérieure de la couche diélectrique.

Avantageusement, on peut remplir les cavités de la première nanostructuration de la couche diélectrique, par un métal au-delà de la surface supérieure de la couche diélectrique c'est-à-dire que le métal dépasse de cette surface.

Avantageusement, le métal qui dépasse au-delà de la surface supérieure de la couche diélectrique peut former des motifs en relief d'une hauteur de un à 100 nm par rapport au niveau de la surface supérieure de la couche diélectrique.

Avantageusement, la première nanostructuration ou nanostructuration diélectrique peut être constituée par un réseau périodique, tel qu'un réseau à une dimension ou un réseau à deux dimensions.

Plus particulièrement, la première nanostructuration peut être un réseau de lignes avec des motifs périodiques d'une période P1 de préférence de 100 nm à 1 µm, de préférence encore de 200 à 600 nm et d'une hauteur h1 de préférence de 5 nm à 100 nm, ou un réseau de plots.

Avantageusement, les lignes de la première nanostructuration peuvent avoir une largeur de 50 nm à 550 nm.

Lorsque la première nanostructuration est un réseau de lignes, alors la seconde nanostructuration est aussi un réseau de lignes avec des motifs périodiques d'une période P2 de préférence de 100 nm à 1 µm, de préférence encore de 200 nm à 600 nm et d'une hauteur h2 de préférence de 5 nm à 100 nm.

Il est à noter que les deux nanostructurations ont forcément la même période.

Avantageusement, les lignes de la seconde nanostructuration ont une largeur de 50 nm à 550 nm.

Pour un renforcement de l'extraction dans les domaines visibles, il est préférable d'utiliser des réseaux présentant une période comprise entre 200 nm et 600 nm.

Pour le filtrage coloré, il est préférable d'utiliser des réseaux (métal/diélectrique) présentant une période comprise entre 300 nm et 600 nm.

On peut viser soit le renforcement de l'extraction, soit le filtrage coloré, mais généralement, on recherche à la fois ces deux objectifs.

Le procédé selon l'invention peut être défini comme un procédé de réalisation de nanostructures métalliques et diélectriques pour le filtrage coloré et le renforcement de l'extraction lumineuse dans les diodes électroluminescentes organiques OLEDs. Le procédé selon l'invention peut être plus particulièrement défini comme un procédé de réalisation de réseaux métal/diélectriques permettant un renforcement de l'extraction, un filtrage coloré et une connexion électrique d'une OLED notamment par la surface de l'anode.

Le procédé selon l'invention comprend une succession spécifique d'étapes qui n'a jamais été décrite ni suggérée dans l'art antérieur, tel que représenté notamment par les documents cités plus haut.

Le procédé selon l'invention permet d'obtenir un filtrage coloré sans étape de gravure de métal, ni étape de remplissage diélectrique, ni étape de polissage mécano-chimique (« CMP ») qui sont, dans les procédés de l'art antérieur, les étapes les plus difficiles à mettre en oeuvre.

En particulier, le procédé selon l'invention ne comporte pas d'étape de polissage mécano-chimique et le procédé selon l'invention évite de ce fait tous les inconvénients liés à cette opération. Notamment, le procédé selon l'invention permet de réaliser facilement des nanostructurations avec des densités de motifs différentes sans qu'il soit nécessaire d'utiliser des motifs fictifs, nécessaires lors de ce polissage mécano-chimique. En supprimant, grâce au procédé selon l'invention, ces motifs fictifs, on accroît ainsi la surface d'émission.

Le procédé selon l'invention permet en conséquence de réaliser facilement côte à côte des pixels avec des filtrages colorés différents.

Le procédé selon l'invention renforce globalement l'extraction de la lumière de l'OLED et rend possible l'adressage électrique individuel de chaque pixel.

Le procédé selon l'invention, de fabrication d'une électrode, telle qu'une anode comprenant une surface avec une nanostructuration métal/diélectrique sur un substrat pour une diode électroluminescente organique OLED, répond entre autres à l'ensemble des besoins énumérés plus haut et apporte une solution aux problèmes des procédés de l'art antérieur.

Le procédé selon l'invention est simple, fiable, facile à mettre en oeuvre et permet de préparer facilement, de manière contrôlée, reproductible des surfaces dont la nanostructuration, est parfaitement précisément, contrôlée, maîtrisée.

La forme des motifs composant les réseaux d'extraction de la diode est généralement parfaitement maîtrisée et une extraction renforcée mais aussi précisément modulée peut être obtenue.

L'invention concerne, en outre, un procédé de fabrication d'une diode électroluminescente organique OLED comprenant au moins une étape de fabrication d'une électrode comprenant une surface comprenant une première nanostructuration diélectrique et une seconde nanostructuration métallique, sur un substrat, ladite étape étant réalisée par le procédé tel que décrit plus haut.

Ce procédé de fabrication d'une OLED présente de manière inhérente tous les avantages et les effets déjà mentionnés plus haut liés au procédé selon l'invention, de fabrication d'une électrode comprenant une surface comprenant une nanostructuration métallique et une nanostructuration diélectrique, sur un substrat, et les avantages du procédé de fabrication d'une diode électroluminescente organique OLED selon l'invention découlent pour l'essentiel du procédé de fabrication selon l'invention, d'une électrode comprenant une surface comprenant une nanostructuration métallique et une nanostructuration diélectrique et ont été déjà largement exposés plus haut.

Avantageusement, dans le procédé de fabrication d'une OLED selon l'invention, on fabrique une première électrode comprenant une surface comprenant une première nanostructuration diélectrique et une seconde nanostructuration métallique, sur un substrat, par le procédé selon l'invention, puis on dépose successivement sur la surface nanostructurée de la première électrode une ou plusieurs couche(s) organique(s) émettrice(s) conforme(s) à la surface nanostructurée de la première électrode, et une couche de seconde électrode conforme à la surface nanostructurée de la première électrode.

De préférence, la première électrode est une anode et la seconde électrode est une cathode.

Avantageusement, on peut déposer en outre sur la première électrode une ou plusieurs autre(s) couche(s) conforme(s) à la surface nanostructurée de la première électrode, choisie(s) parmi une couche d'injection de trous, une couche de transport de trous, une couche d'injection d'électrons, une couche de transport d'électrons, une couche de blocage de trous, une couche de blocage d'électrons, et une couche de transistors à couches minces (« TFT »), deux ou plusieurs parmi cette ou ces autre(s) couche(s), la ou les couche(s) organique(s) émettrice(s), la couche de première électrode et la couche de seconde électrode pouvant être confondues.

L'invention sera mieux comprise à la lecture de la description détaillée qui va suivre, faite à titre illustratif et non limitatif, en référence aux dessins joints dans lesquels:

### BRÈVE DESCRIPTION DES DESSINS

- La figure 1 est une vue schématique en coupe verticale d'une diode électroluminescente organique (« Organic Light Emitting Diode » ou « OLED » en anglais) ;
- La figure 2 est une vue schématique en coupe verticale d'une OLED avec des nanostructurations permettant l'extraction optique ;
- La figure 3A est une vue schématique en coupe verticale d'une OLED dont les couches organiques, l'anode et la cathode présentent des motifs avec une pente trop importante susceptibles de provoquer des courts-circuits ;
- La figure 3B est une vue schématique en coupe verticale d'une OLED dont les couches organiques, l'anode et la cathode présentent des motifs avec des défauts susceptibles de provoquer des courts-circuits ;
- La figure 4 est une vue schématique en coupe verticale d'une OLED selon l'art antérieur dans laquelle le filtrage coloré est obtenu en collant des filtres colorés sur l'élément OLED ;
- Les figures 5A à 5C sont des vues schématiques en coupe verticale qui illustrent les étapes successives de fabrication d'une OLED sans filtre coloré dans laquelle le filtrage coloré est obtenu par des réseaux métal-diélectriques ;
- Les figures 6A à 6G sont des vues schématiques en coupe verticale qui illustrent les étapes successives de fabrication d'une électrode (anode) comprenant une surface comprenant une nanostructuration métallique et une nanostructuration diélectrique sur un substrat, par le procédé selon l'invention (figures 6A à 6E), puis les étapes de fabrication d'une OLED sur cette électrode (figures 6F à 6G).

### EXPOSÉ DÉTAILLÉ DE MODES DE RÉALISATION PARTICULIERS

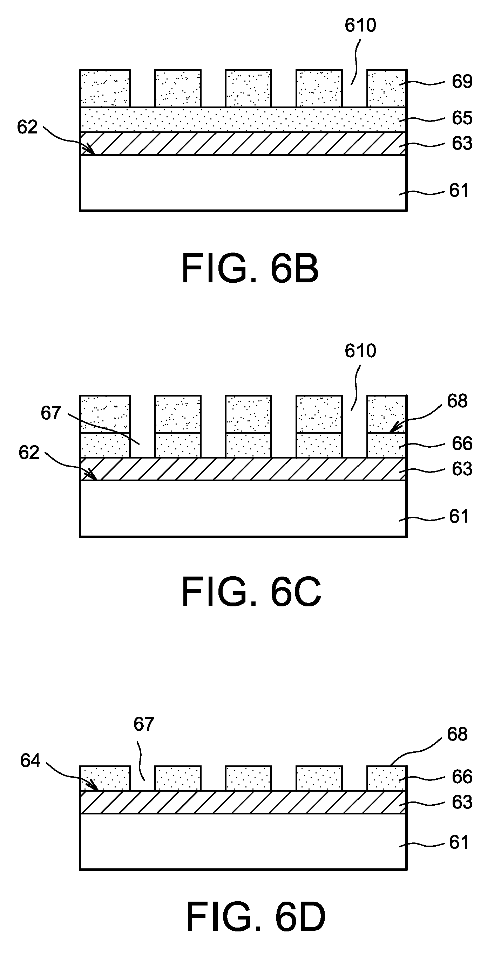

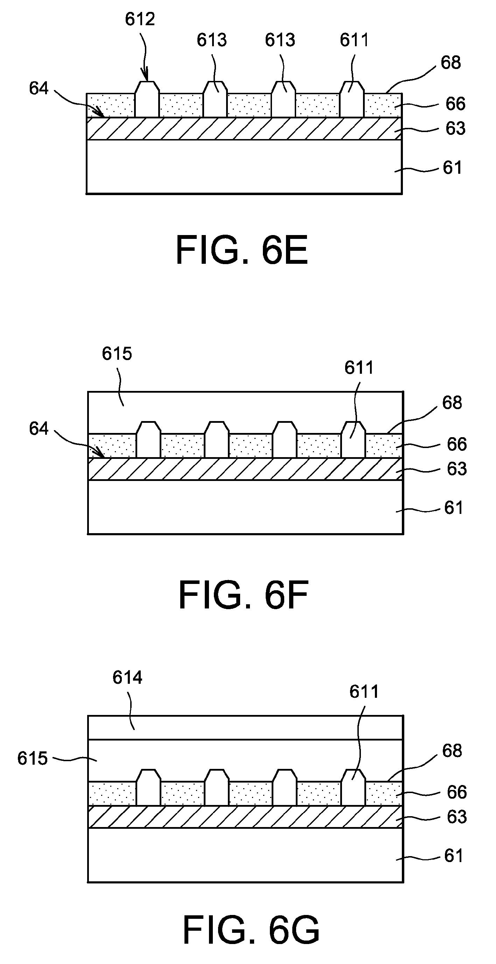

Le procédé de fabrication selon l'invention, d'une électrode telle qu'une anode pour une diode électroluminescente organique OLED, comprenant une surface comprenant une nanostructuration métallique et une nanostructuration diélectrique, sur un substrat (voir Figures 6A, 6B, 6C, 6D, 6E, 6F, 6G), comprend tout d'abord une étape au cours de laquelle on dépose une couche métallique (63), sur une surface plane (62) d'un substrat (61).

Le substrat ou superstrat (61) selon la disposition de la diode électroluminescente organique peut être en tout matériau convenant pour la fabrication d'un substrat pour une OLED.

Le substrat (61) peut être un substrat transparent, c'est-à-dire qui transmet la lumière, de préférence la lumière visible, ou bien un substrat opaque.

Il est bien sûr souhaitable que le substrat transmette la lumière, soit transparent, dans le cas où l'émission de lumière se fait au-travers du substrat qui est alors généralement plutôt un « superstrat ».

Des exemples de matériaux transparents adéquats sont les verres, les céramiques transparentes et les plastiques transparents.

Dans le cas où l'émission de lumière se fait par l'électrode supérieure qui est généralement la cathode alors le substrat peut être aussi bien un substrat transmettant la lumière, qu'un substrat réfléchissant la lumière ou qu'un substrat absorbant la lumière.

Le substrat (61) comporte au moins une surface plane, généralement sa surface supérieure (62) sur laquelle la couche métallique (63) est déposée.

Le substrat (61) peut ainsi avoir la forme d'une plaque ou plaquette comprenant deux surfaces planes parallèles, par exemple carrées, rectangulaires ou encore circulaires.

Cette plaquette peut avoir une épaisseur de un ou quelques microns (2, 3, 5, 10 µm) à un ou quelques millimètres (2, 3, 5, 10 mm), de préférence de 1 µm à 3 mm, de préférence entre 10 µm et 2 mm, et une surface par exemple sous la forme d'un disque présentant un diamètre de 20 ou 30 cm.

La couche métallique (63) est généralement en un métal choisi parmi le platine, le cobalt, le nickel, le fer, l'argent, l'aluminium, l'iridium, l'or, le molybdène, le palladium ; et leurs alliages.

La couche métallique (63) peut être déposée par un procédé choisi parmi le dépôt chimique en phase vapeur (« CVD »), le dépôt chimique en phase vapeur assisté par plasma (« PECVD » ou « PACVD »), le dépôt physique en phase vapeur (« PVD ») et la pulvérisation.

La couche métallique a généralement une épaisseur de 10 nm jusqu'à 100 ou quelques centaines de nm, par exemple 200, 300, 500, 600 ou 1000 nm ; de préférence la couche métallique a une épaisseur de 10 nm à 200 nm, de préférence encore de 100 nm à 300 nm.

Dans une deuxième étape du procédé selon l'invention, on prépare sur la couche métallique (63), ou plus précisément sur la surface supérieure (64) de la couche métallique (63), une couche diélectrique (65) comprenant une première nanostructuration (66), que l'on peut aussi dénommer nanostructuration diélectrique (66). Cette nanostructuration (66) comporte des cavités (67), qui s'étendent depuis la surface supérieure (68) de la couche diélectrique (65) jusqu'à la surface supérieure (64) de la couche métallique (63).

Dans un premier mode de réalisation de cette deuxième étape du procédé selon l'invention, la couche diélectrique (63) comprenant la première nanostructuration (66) est préparée en déposant une couche en un matériau diélectrique (65) puis une couche de résine (69), que l'on peut appeler couche de résine à structurer sur la couche métallique (63) (voir Figure 6A) ; en procédant à la lithographie (voir Figure 6B) de la couche de résine (69) pour éliminer la résine dans des zones (610) correspondant aux cavités (67) à définir dans la couche diélectrique (65), en gravant la couche diélectrique (65) pour définir les cavités (67) (voir Figure 6C), et enfin en retirant la résine (voir Figure 6D).

Le matériau diélectrique déposé peut être choisi parmi SiO₂, HfO₂ et les isolants électriques, en d'autres termes les matériaux isolants électriquement.

Cette couche en un matériau diélectrique peut être déposée par un procédé choisi parmi le dépôt chimique en phase vapeur (« CVD »), le dépôt chimique en phase vapeur assisté par plasma (« PECVD » ou « PACVD »), le dépôt physique en phase vapeur (« PVD ») et la pulvérisation.

Cette couche en un matériau diélectrique a généralement une épaisseur de 10 nm à 200 nm avantageusement.

Sur la couche de matériau diélectrique ainsi déposée, on dépose une couche de résine (69) (voir Figure 6A).

Dans ce premier mode de réalisation de la deuxième étape du procédé selon l'invention, la résine (69) est ensuite éliminée, retirée, avant que l'on ne procède au remplissage des cavités (67) des nanostructurations diélectriques et n'est donc pas présente lors de cette étape, ni ensuite lors des étapes ultérieures de fabrication de l'OLED, ni dans l'OLED finale prête à fonctionner.

En conséquence, il n'est pas nécessaire que la résine mise en oeuvre soit compatible avec le procédé utilisé pour remplir les cavités des premières nanostructurations, tel qu'un procédé d'électrochimie. Il n'est pas non plus nécessaire que cette résine puisse résister aux étapes ultérieures de fabrication de l'OLED, telles que dépôts de couches, recuits, gravures etc.

Il n'est enfin pas nécessaire que cette résine présente les propriétés requises pour pouvoir supporter les conditions d'utilisation de l'OLED telles que résistance thermique, résistance au vieillissement, et tenue mécanique.

Dans ce premier mode de réalisation de la deuxième étape du procédé selon l'invention, le choix de la résine sera donc fait généralement simplement en fonction de ses capacités résolvantes et en fonction de la technique de lithographie utilisée dans l'étape suivante. Ainsi dans le cas où l'on utilise une technique de lithographie optique ou électronique ou lithographie de nanoimpression assistée par UV, on utilisera généralement une résine photosensible telle qu'une résine à base de groupements méthacrylate ou une résine polyhydroxystyrène.

Un large choix de produits commerciaux est disponible suivant la méthode employée.

Dans le cas où l'on utilise une technique de lithographie par nanoimpression thermique, la résine n'est pas obligatoirement photosensible, et elle doit alors simplement présenter une température de fusion ou de transition vitreuse.

Rappelons que la température de transition vitreuse (Tg) est la température à laquelle certains polymères passent d'un état solide dur vitreux à un état plastique. Au-dessus de cette température, on peut dire que ces résines, polymères sont fluides et peuvent donc s'écouler.

La résine, dans le cas où l'on utilise une technique de lithographie par nanoimpression thermique pourra donc être avantageusement choisie parmi les résines thermoplastiques et les résines thermodurcissables.

Par résine, on entend également les mélanges de deux résines ou plus.

Des exemples de résines sont les polystyrènes (PS), les poly(méthacrylate de méthyle)s (PMMA), les polyesters insaturés, les résines époxydes, les résines phénoliques, les polyimides, les polyamides, les polycarbonates, les polyoléfines tels que les polypropylènes, le POSS ou « polyhedral oligomeric silsesquioxane », et les mélanges de celles-ci.

La résine de la couche de résine (69) peut éventuellement subir un traitement thermique notamment dans le cas du POSS, si l'on souhaite réaliser une transformation en un matériau diélectrique. Sinon pour l'utilisation en nanoimpression, un tel traitement thermique n'est pas absolument nécessaire.

Dans le cas des résines, polymères, thermodurcissables, celui-ci peut être appliqué sous la forme d'une composition en deux parties comprenant les précurseurs de la résine avec par exemple d'une part une formulation et d'autre part un agent de réticulation, durcissement.

La couche de résine organique (69) peut être déposée par une technique choisie parmi les techniques suivantes:
- le trempage-retrait (connu sous la terminologie anglaise « dip-coating ») ;
- l'enduction centrifuge (connue sous la terminologie anglaise « spin-coating ») ;
- l'enduction laminaire (connue sous la terminologie anglaise « laminar-flow-coating ») ;
- la pulvérisation (connue sous la terminologie anglaise « spray-coating ») ;
- l'épandage (connu sous la terminologie anglaise « soak coating ») ;
- l'enduction au rouleau (connue sous la terminologie « roll to roll process ») ;
- l'enduction au pinceau (connue sous la terminologie anglaise « painting coating ») ;
- la sérigraphie (connue sous la terminologie anglaise « screen printing »).

Toutes ces techniques peuvent être utilisées dans le procédé de l'invention surtout si l'on souhaite déposer des couches « épaisses », comme par exemple de l'ordre de 10 µm.

Dans ces techniques et notamment dans la technique d'enduction centrifuge, on met en oeuvre une solution de la résine, du polymère organique dans un solvant, généralement un solvant organique adéquat. A titre d'exemple, si le polymère est le poly(méthacrylate de méthyle) (PMMA), on pourra utiliser une solution de ce polymère dans le toluène.

La technique préférée est la technique d'enduction centrifuge ou bien la technique de pulvérisation. Outre les techniques en solution, on peut aussi utiliser pour le dépôt de la couche de résine, le dépôt chimique en phase vapeur (« CVD »), ou le dépôt chimique en phase vapeur assisté par plasma (« PECVD « ou « PACVD »).

La couche déposée est de préférence une couche mince ou un film de résine (69). Par couche mince (69), on entend généralement que la couche de résine (69) a une épaisseur comprise entre quelques nanomètres et quelques centaines de nanomètres, de préférence de 10 à 500 nm.

A l'issue du dépôt de la résine, on procède à la lithographie de la couche de résine (Figure 6B) pour éliminer la résine dans des zones (610) de la couche de résine (69) correspondant aux cavités (67) à définir dans la couche diélectrique (65).

En d'autres termes, on prépare au cours de cette étape de lithographie de la couche de résine déposée (69) un masque de gravure, et on définit ainsi dans la couche de résine un motif qui correspond au motif que l'on souhaite obtenir ensuite dans la couche de matériau diélectrique (65) sous-jacente.

Comme on l'a déjà précisé plus haut, la technique de lithographie peut être une technique de lithographie optique ou électronique, une technique de lithographie de nanoimpression assistée par UV ou une technique de lithographie par nanoimpression thermique.

Selon le premier mode de réalisation de la deuxième étape du procédé selon l'invention, on effectue ensuite, à l'aide de la couche de résine lithographiée préparée comme décrit plus haut et jouant le rôle de masque, la gravure de la couche diélectrique (65) (voir Figure 6C). La gravure de la couche diélectrique (65) peut être réalisée par tout procédé de gravure connu, standard choisi par exemple parmi les procédés de gravure humide ou sèche réactive tels que le « Reactive Ion Etching » ou « RIE ». Ces procédés permettent de transférer le motif de la couche de résine (69) à la couche de matériau diélectrique sous-jacente (65).

On définit ainsi dans la couche diélectrique (65) une première nanostructuration (66) ou nanostructuration diélectrique, comportant des cavités (67) qui s'étendent depuis la surface supérieure (68) de la couche diélectrique jusqu'à la surface supérieure (64) de la couche métallique (63).

La nanostructuration de la couche diélectrique peut être constituée par un réseau périodique.

Ce réseau périodique peut être un réseau à une dimension ou un réseau à deux dimensions.

Un tel réseau à une dimension pourra par exemple être un réseau de lignes avec des motifs périodiques d'une période P (P1 en référence à la première nanostructuration) et d'une hauteur h (h1 en référence à la première nanostructuration) (voir la figure 2).

La période P1 peut être de 100 nm à quelques micromètres, de préférence de 100 nm à 1 µm, de préférence de 200 à 600 nm, et la hauteur h1 peut être d'au moins 5 nm à 100 nm, de préférence de 5 nm à 40 nm.

Le réseau peut être un réseau à deux dimensions. En effet, on peut réaliser des réseaux de trous avec différentes formes. Pour connaître la meilleure géométrie, il faut alors réaliser des simulations du comportement optique de ces structures. Un tel réseau à deux dimensions pourra être choisi notamment parmi les réseaux carrés, les réseaux triangulaires, rectangulaires, hexagonaux, et les réseaux plus complexes tels que les réseaux d'Archimède.

Le réseau peut aussi être un réseau de plots.

Il est à noter que la première nanostructuration présente généralement des motifs géométriques simples, non arrondis.

Par exemple, les lignes peuvent avoir une section transversale triangulaire (figure 3A), rectangulaire ou carrée (figures 4C, 4D). On préférera des lignes avec une section transversale rectangulaire ou carrée, avec une hauteur h1 telle que définie plus haut et une largeur des lignes de 50 nm à 550 nm.

La nanostructuration (66) obtenue dans la couche diélectrique (65) comporte des cavités définies entre les motifs en matériau diélectrique. Cette nanostructuration peut être qualifiée de première nanostructuration ou nanostructuration diélectrique.

Dans le cas d'un réseau de lignes, ces cavités sont constituées par les vides, vallées existant entre les lignes. Lorsque les lignes ont une section transversale rectangulaire ou carrée, les cavités se présentent aussi généralement sous la forme de lignes avec également une section transversale rectangulaire ou carrée avec une hauteur (profondeur) h1 telle que définie plus haut, et une largeur de 50 nm à 550 nm.

On procède ensuite au retrait de la résine (voir Figure 6D) par tout procédé connu de l'homme du métier tel qu'un procédé connu sous le nom de « stripping » comprenant des étapes de traitement au plasma et/ou de gravure humide.

Dans un deuxième mode de réalisation de la deuxième étape du procédé selon l'invention (non représenté sur les figures), la couche diélectrique comprenant des nanostructurations peut être préparée en déposant une couche en une résine diélectrique ou en une résine ou en un matériau, ladite résine ou ledit matériau étant susceptible d'être converti(e), transformé(e), en un matériau ou résine diélectrique, sur la couche métallique et en lithographiant, imprimant ou gravant la couche en résine diélectrique ou en une résine ou en un matériau susceptible d'être transformé(e) en un matériau ou une résine diélectrique pour y définir les cavités.

Ce matériau diélectrique tel qu'une résine est généralement différent de la résine du premier mode de réalisation essentiellement du fait de sa formulation chimique, qui change, et du fait que les matériaux tels que des résines mis en oeuvre dans le second mode de réalisation sont généralement stables pour des températures supérieures par exemple à 400°C/500°C, ce qui n'est pas évident à obtenir avec les autres résines.

Typiquement, ces matériaux tels que des résines ne sont pas purement organiques et contiennent des composants minéraux tels que le silicium.

Le matériau diélectrique tel qu'une résine diélectrique est présent lorsque l'on procède au remplissage des cavités des nanostructurations diélectriques ainsi que lors des étapes ultérieures de fabrication de l'OLED. Cette résine est également présente dans l'OLED finale prête à fonctionner.

En conséquence, à la différence de la résine utilisée dans le premier mode de réalisation, il est nécessaire que le matériau diélectrique tel qu'une résine mis en oeuvre dans ce second mode de réalisation de la deuxième étape du procédé selon l'invention, soit compatible avec le procédé utilisé ensuite pour remplir les cavités des premières nanostructurations, tel qu'un procédé d'électrochimie.

Plus précisément, le matériau diélectrique tel qu'une résine diélectrique utilisé dans ce second mode de réalisation de la deuxième étape du procédé selon l'invention devra généralement être choisi de manière à pouvoir résister aux solutions utilisées pour réaliser la croissance électrochimique des nanostructurations métalliques lors de l'étape c) du procédé selon l'invention, afin que la première nanostructuration, les motifs diélectriques ne soient pas altérés, détériorés.

Il est également nécessaire que cette résine puisse résister aux étapes ultérieures de fabrication de l'OLED, telles que dépôts de couches, recuits, gravures etc.

Il est enfin nécessaire que ce matériau, par exemple cette résine, présente les propriétés requises pour pouvoir supporter les conditions d'utilisation de l'OLED telles que résistance thermique, résistance au vieillissement, et tenue mécanique.

Le matériau diélectrique, par exemple la résine diélectrique, est donc choisi en fonction des critères énumérés ci-dessus, mais aussi comme la résine mise en oeuvre dans le premier mode de réalisation en fonction de ses capacités résolvantes et en fonction du procédé de lithographie mis en oeuvre.

Le matériau ou résine qui sera transformé(e) en un matériau diélectrique est généralement choisi parmi les matériaux appelés « spin-on-glass » ou « verres centrifugés ».

Ces verres sont préparés par étalement par enduction centrifuge (tournette, « spin coating ») d'une solution.

Après traitement thermique consistant généralement en un séchage, évaporation, puis en un recuit du matériau ou de la résine susceptible d'être transformé(e) en un matériau ou résine diélectrique, on obtient une couche de matériau ou résine diélectrique, par exemple une couche constituée essentiellement de SiO₂.

Les précurseurs ou matériaux susceptibles d'être transformés en un matériau diélectrique peuvent être choisis parmi le hydrogéno silsesquioxane (HSQ) ; et les POSS.

Si l'on utilise pour graver cette couche un procédé de lithographie par nanoimpression thermique, la résine ou matériau diélectrique est avantageusement choisi(e) parmi les résines organiques déjà citées plus haut, à la condition qu'elles présentent une température de transition vitreuse Tg ou une température de fusion supérieure à la ou aux température(s) de dépôt(s) ultérieur(s) d'une ou plusieurs autre(s) couche(s).

Typiquement, cette Tg ou cette température de fusion est supérieure à la température de dépôt des OLEDS et du film métallique pour l'anode.

Par température de transition vitreuse ou température de fusion supérieure à la ou aux température(s) de dépôt, on entend généralement que la température de transition vitreuse ou la température de fusion de la résine organique est supérieure d'au moins 5°C, et de préférence d'au moins 20°C à la température de dépôt la plus élevée utilisée pour le dépôt ultérieur de la ou des autres couches.

Cette ou ces autres couche(s) sont les couches aussi bien organiques que minérales ou métalliques qui entrent dans la constitution d'une diode électroluminescente organique et seront décrites en détail plus bas.

En choisissant une telle résine organique avec une telle température de transition vitreuse ou une telle température de fusion, pour constituer la couche de résine organique, qui forme ensuite la nanostructuration de l'électrode, on évite que la nanostructuration soit déformée thermiquement au cours des étapes de dépôt de couches qui interviennent ensuite dans la fabrication de l'OLED, et on assure ainsi que la nanostructuration diélectrique obtenue à l'issue du procédé selon l'invention soit intégralement conservée après chaque étape de fabrication de l'OLED et à la fin du procédé complet de fabrication de l'OLED.

Cette couche en résine diélectrique ou en un matériau susceptible d'être transformé(e) en une résine ou en un matériau diélectrique est déposée par un procédé choisi parmi les procédés déjà mentionnés plus haut pour la couche de résine organique dans le cadre du premier mode de réalisation.

L'épaisseur de la couche de résine diélectrique ou de résine ou matériau susceptible d'être transformé(e) en une résine ou en un matériau diélectrique est généralement de 10 nm à 100 nm.

A l'issue du dépôt de la couche de résine diélectrique ou de la couche en un matériau ou résine susceptible d'être transformé(e) en un matériau ou résine diélectrique, on procède ensuite, conformément au second mode de réalisation de la deuxième étape du procédé selon l'invention, à la lithographie, gravure, impression de cette couche de manière à définir dans celle-ci les cavités voulues et à préparer ainsi une couche diélectrique comprenant les nanostructurations recherchées.

La lithographie de cette couche est réalisée par une des techniques déjà énumérées plus haut pour la lithographie de la couche de résine organique dans le premier mode de réalisation de la deuxième étape du procédé selon l'invention.

Si l'on a mis en oeuvre une couche de matériau ou de résine susceptible d'être transformé(e) en un matériau ou une résine diélectrique, le matériau ou la résine est transformé(e) en résine diélectrique par un traitement thermique comme on l'a décrit plus haut dans le cas des verres centrifugés.

La nanostructuration de la couche de matériau diélectrique obtenue à l'issue de la deuxième étape du procédé selon l'invention, dans ce second mode de réalisation est généralement analogue à celle obtenue dans le premier mode de réalisation.

Suite à la deuxième étape du procédé selon l'invention, on réalise la troisième étape (étape c)) du procédé selon l'invention, au cours de laquelle on remplit au moins partiellement les cavités (67) de la nanostructuration (66) de la couche diélectrique (65), par un métal ou alliage (611), de préférence on remplit les cavités (67) au moins partiellement jusqu'à la surface supérieure (68) de la couche diélectrique (65).

Ce métal ou alliage (611) peut être le même métal ou alliage que celui qui constitue la couche métallique, ou il peut s'agir d'un métal ou alliage différent. Ce métal ou alliage (611) est généralement choisi parmi le platine, le cobalt, le nickel, le fer, l'argent, l'aluminium, l'iridium, l'or, le molybdène, le palladium ; et leurs alliages.

Les cavités (67) sont remplies au moins partiellement par le métal ou alliage.

Si le remplissage est un remplissage partiel, alors le motif métallique est un motif « en creux ».

De préférence, les cavités (67) sont remplies par le métal ou alliage au moins jusqu'à la surface supérieure (68), généralement plane de la couche diélectrique (65). Cependant on ne cherchera pas pour autant à obtenir systématiquement une surface du métal (612) parfaitement plane. C'est-à-dire que l'on ne cherchera généralement pas à obtenir une surface supérieure (612) du métal ou alliage (611) remplissant les cavités (67), parfaitement plane, se situant exactement dans le même plan que la surface supérieure (68) de la couche diélectrique (la surface supérieure (68) de la couche diélectrique est généralement constituée par la surface supérieure, généralement plane des motifs (66) tels que des lignes de diélectrique définies dans la couche diélectrique), ne présentant aucun relief par rapport à cette surface supérieure de la couche diélectrique.

Il est en effet généralement avantageux que le métal ou alliage (611) remplisse les cavités (67) au-delà de la surface supérieure (68), généralement plane de la couche diélectrique et dépasse donc de cette surface supérieure, pour former des motifs (613) en relief, en saillie par rapport au plan de la surface supérieure (68) de la couche diélectrique (65).

Autrement dit, la présence d'une topographie, de préférence d'une petite topographie est généralement avantageuse car elle peut permettre de renforcer l'extraction sans pour autant créer des défauts dans l'OLED.

Par « petite topographie », on entend que la hauteur des motifs (613) en métal qui sont en saillie, en relief, par rapport au niveau de la surface supérieure de la couche diélectrique peut aller de un à quelques nanomètres (2, 3, 4, 5 nm) jusqu'à 10 à quelques dizaines de nanomètres, par exemple 100 nm.

La forme de ces motifs, de cette topographie en métal peut être quelconque.

Cette forme n'est généralement pas parfaitement contrôlée.

Le remplissage (Figure 6E) des cavités de la nanostructuration de la couche diélectrique par un métal est réalisé par un procédé électrochimique.

Plus précisément, le remplissage des cavités consiste à effectuer la croissance électrochimique d'ilots métalliques dans les cavités de la couche diélectrique.

Cette croissance électrochimique peut être réalisée par deux types de procédés:
- les procédés d'électro-déposition aussi appelés procédés de dépôt électrolytique ou de galvanoplastie:
   ils sont réalisés en imposant un potentiel ou un courant ;
- les procédés d'électro-réduction sans courant appelés procédés « e-less ».

La croissance du dépôt par électrodéposition a lieu sur les surfaces métalliques ou semi-conductrices que l'on polarise ; la réduction des cations métalliques contenus dans l'électrolyte (bain de dépôt) a lieu sur les surfaces polarisées. Le contrôle de la croissance se fait par ajustement du potentiel ou du courant imposé. Bien que le mode potentiostatique (potentiel contrôlé) permette de mieux contrôler les réactions interfaciales, les procédés industriels sont souvent galvanostatiques (courant contrôlé). Selon le potentiel ou courant imposé, pulsé ou constant, la nature et la structure du dépôt varie. Le mode de croissance dépend également des forces d'interactions entre le substrat et le métal déposé comme cela est mentionné dans le document de E. Budevski, G. Staikov, et W.J. Lorenz, Electrochemical Phase Formation and Growth, VCH, Weinheim 1996 [8].

Dans le second cas, la réduction des cations métalliques se fait sur le substrat par un agent réducteur également contenu dans la solution de dépôt. La réaction de réduction est catalysée par le substrat lui-même ou par des nucléis (germes) préalablement déposés pour activer la surface (étape nécessaire dans le cas des substrats non conducteurs). L'inconvénient de l' « eless » est la difficulté à contrôler le début et la fin de la réaction mais on peut faire varier la température, le temps de dépôt et les concentrations des différents réactifs de l'électrolyte. Contrairement à l'e-less, l'électrodéposition offre la possibilité de mieux contrôler le procédé par ajustement du potentiel ou du courant en plus des autres paramètres précédemment cités (M. Paunovic, M. Electrochemical Deposition, (2006) [9]).

Les techniques de croissance électrochimiques permettent d'obtenir des structures allant jusqu'aux tailles nanométriques dans des conditions optimisées. Cependant, la répartition en taille, la densité ainsi que la localisation des nanostructures restent aléatoires. Aussi, le couplage de ces techniques avec l'utilisation d'un masque est une solution pour obtenir des structures régulières aux dimensions souhaitées, dans la mesure où les solutions de dépôt sont compatibles avec le matériau constituant le masque.

Pour mettre en oeuvre le procédé d'électro-déposition, il est nécessaire d'avoir un contact électrique sur la couche métallique se trouvant en dessous de la couche de diélectrique et du masque. Pour ce faire, on peut envisager de faire un détourage de la plaque afin d'enlever la partie diélectrique + masque et prendre le contact. Dans le cas du dépôt « e-less », aucune préparation de plaque n'est nécessaire ; par contre, il faudra veiller à ce que les paramètres de dépôt tels que la température et le pH soient choisis de façon à ce que le masque ou plus exactement la nanostructuration dans le diélectrique (66) ne soit pas endommagée.

Un grand nombre de procédés standards existent tels que le dépôt de platine [10], [11], [12], cobalt [13], [14], [15], nickel [16], [17], [18], [13], [19], fer [17], [14], [13], [19], argent [20], [21], [22], [23] etc. et sont réalisés en milieux aqueux.

D'autres dépôts difficiles à réaliser en solution aqueuse tels que celui de l'aluminium peuvent être mis en oeuvre dans des électrolytes non aqueux tels que les liquides ioniques [24], [25].

A l'issue de cette étape de remplissage des cavités de la nanostructuration de la couche diélectrique, on obtient ainsi une électrode, telle qu'une anode, comprenant une surface comprenant à la fois une nanostructuration métallique et une nanostructuration diélectrique. La nanostructuration métallique correspond en fait aux cavités (67) de la première nanostructuration qui ont été remplies de métal (611).

Ainsi, dans le cas d'une première nanostructuration ou nanostructuration diélectrique constituée par un réseau de lignes, la seconde nanostructuration ou nanostructuration métallique est également constituée par un réseau de lignes avec des motifs périodiques d'une période P2 et d'une hauteur h2. La période P2 du réseau de lignes métalliques peut être de 100 nm à quelques micromètres, de préférence de 100 nm à 1 µm, de préférence de 200 nm à 600 nm, et la hauteur h2 peut être d'au moins 5 nm à 100 nm, de préférence de 5 nm à 40 nm. La hauteur h2 est généralement égale à la hauteur h1, mais à cette hauteur h1, il y a généralement lieu d'ajouter la hauteur de l'éventuelle topologie métallique au-dessus de la surface supérieure de la couche diélectrique si bien que la hauteur des motifs de la seconde nanostructuration sera alors supérieure à la hauteur h1.

Lorsque les lignes de la nanostructuration diélectrique ont une section transversale rectangulaire ou carrée, les lignes de la nanostructuration métallique ont également une section transversale rectangulaire ou carrée avec une hauteur h2 telle que définie plus haut égale à celle des lignes de la nanostructuration diélectrique (plus éventuellement la hauteur de la topologie au-dessus de la surface supérieure de la couche diélectrique), et une largeur de 50 nm à 550 nm (voir Figure 6E).

Typiquement, la surface de l'électrode peut ainsi comporter un réseau de lignes diélectriques avec une largeur de 50 nm à 550 nm et un réseau de lignes métalliques avec une largeur de 50 nm à 550 nm.

En ajustant la largeur de la ligne métallique et de la ligne diélectrique, on peut facilement choisir la couleur qui sera extraite de l'OLED.

Ceci peut être réalisé par des calculs d'ingénierie optique.

Il faut connaître les indices optiques du métal et diélectriques utilisés et la géométrie peut être ainsi simulée pour déterminer les meilleures formes à réaliser.

On peut ensuite fabriquer une diode électroluminescente organique OLED qui comprend en tant qu'électrode, de préférence en tant qu'anode, l'anode fabriquée par le procédé selon l'invention décrit ci-dessus.

Toute diode électroluminescente organique peut être fabriquée par le procédé selon l'invention, à la condition qu'au moins une de ses électrodes soit préparée par le procédé selon l'invention tel que décrit plus haut.

Pour fabriquer cette diode électroluminescente organique, on dépose successivement et de manière conforme à la surface nanostructurée, les diverses couches constituant une OLED sur la surface à nanostructurations électrique et métallique de l'électrode, sur un substrat, préparée par le procédé selon l'invention.

Il est à noter que toute description relative à la nature, au nombre, à la disposition, à la forme des couches de l'OLED donnée dans ce qui suit ne l'est qu'à titre indicatif, illustratif et non limitatif et que les mêmes avantages sont obtenus quels que soient le nombre, la nature, et la disposition de ces couches de l'OLED du moment qu'au moins une des électrodes de l'OLED est une électrode à surface nanostructurée préparée par le procédé selon l'invention.

L'OLED fabriquée par le procédé de fabrication d'une OLED selon l'invention peut être une des OLED décrites plus haut telles que celle décrite sur la Figure 1 ou une OLED telle que décrite dans le document [5] ou [6] ou bien encore dans le document [7].

On supposera dans ce qui suit, mais sans que cela puisse être considéré comme une quelconque limitation, que l'électrode fabriquée par le procédé selon l'invention est l'anode.

De manière très générale, on peut déposer sur l'anode, elle-même déposée sur le substrat, une cathode (614) et des couches organiques émissives (615), les couches organiques émettrices de lumière étant déposées entre l'anode et la cathode. Tous ces dépôts sont bien sûr, conformément à l'invention réalisés de manière conforme à la surface nanostructurée de l'anode.

Au-dessus de l'anode est généralement déposée une couche de transport de trous (encore appelés charges positives) qui contient au moins un composé de transport de trous tel qu'un composé d'amine tertiaire aromatique, un composé aromatique polycyclique, ou un polymère de transport de trous.

Entre la couche de transport de trous et l'anode, il peut être nécessaire de prévoir une couche d'injection de trous qui comprend par exemple des composés porphyriniques ou des amines aromatiques.

La couche d'injection de trous et la couche de transport de trous sont, selon l'invention, conformes aux nanostructurations de la surface de l'anode.

La couche d'injection de trous et la couche de transport de trous peuvent être éventuellement confondues.

Au-dessus de la couche de transport de trous est (sont) déposée(s) une ou plusieurs couche(s) organique(s) émettrice(s).

L'OLED peut ne comprendre qu'une seule couche émettrice mais elle peut éventuellement comprendre plusieurs couches émettrices, par exemple deux ou trois couches émettrices superposées.

Dans le cas où trois couches émettrices sont présentes, ces couches pourront être des couches émettant respectivement dans le bleu, le vert et le rouge pour fournir de la lumière blanche (telle que définie dans le diagramme standard de la CIE de 1931 ou 1976).

L'effet du réseau métal/diélectrique sur la lumière émise peut être déterminé par des simulations.

Les matériaux constituant ces couches émettrices sont connus de l'homme du métier.

Ces couches émettrices sont conformes à la nanostructuration de l'anode.

Cette ou ces couche(s) émettrice(s) sont généralement déposées par évaporation thermique.

Sur la ou les couche(s) émettrice(s), on dépose une couche de transport d'électrons puis une couche d'injection d'électrons qui sont bien entendu conformes à la nanostructuration de l'anode. Ces deux couches peuvent être confondues et elles peuvent éventuellement être confondues avec la ou les couche(s) émettrice(s).

Enfin (voir Figure 6G), on dépose la cathode (615) de l'OLED qui est également, selon l'invention, conforme à la surface nanostructurée de l'anode.

Dans le cas présent, l'émission de lumière se produit au-travers de la cathode, alors celle-ci doit être transparente à la lumière émise et peut être par exemple en oxyde d'indium et d'étain (ITO), ou en oxyde d'indium et de zinc (IZO).

La cathode est généralement déposée par évaporation, pulvérisation cathodique, ou dépôt chimique en phase vapeur.

D'autres couches, également conformes à la surface nanostructurée de l'anode peuvent être prévues, telles qu'une couche de blocage de trous et une couche de blocage d'électrons.

L'invention va maintenant être décrite en référence aux exemples suivants, donnés à titre illustratif et non limitatif.

### EXEMPLES:

### Exemple 1:

Dans cet exemple, on prépare un substrat par le procédé selon l'invention mettant en oeuvre une résine thermodurcissable, puis on prépare une diode électroluminescente organique sur ledit substrat par le procédé selon l'invention.

Le procédé de préparation du substrat comprend les étapes successives suivantes:
- Dépôt par PVD de la couche métallique, par exemple en platine ou d'une couche conductrice d'une épaisseur de 10 nm sur le substrat ;
- Dépôt (ou couchage) de la résine thermodurcissable Neb^{®} 22 de Sumito Chemical Japan disponible dans le commerce sur un « wafer » de silicium de 8 pouces ;
- Compression de la résine à 110°C pendant 5 minutes sous 300 mbar, moyennant quoi on obtient une première nanostructuration qui est un réseau de lignes ou un réseau de plots avec une période de 200 nm à 600 nm et des hauteurs de 5 nm à 40 nm ;
- Après impression, gravure plasma de la couche de résine dite résiduelle qui est présente en-dessous des motifs imprimés pour mettre à nu le substrat et la couche métallique ;
- Croissance par électrochimie des structures conductrices en Cu ou en Au dans les motifs généralement créés par impression et gravure ce jusqu'à atteindre le sommet des trous ainsi faits.

On pourra se permettre de faire dépasser légèrement la croissance pour générer une topographie par rapport à la couche de résine.

Ces motifs conducteurs seront donc en contact électrique avec la couche conductrice sous-jacente.

Ces motifs conducteurs sont entourés par la résine diélectrique et c'est l'ensemble de la couche conductrice et des structures réalisées par électrochimie qui constitue l'anode structurée pour l'OLED.
- Dépôt ensuite des couches « OLED » sur le substrat nanostructuré obtenu.

### Exemple 2:

Dans cet exemple, on dépose une couche conductrice ou métallique, par exemple en TIN, sur un substrat. Puis on dépose une couche de matériau diélectrique (par exemple une couche de 100 nm de dioxyde de silicium).

Sur cette couche diélectrique, on réalise une lithographie optique (à une longueur d'onde de 193 nm) avec une résine commerciale telle qu'une résine disponible auprès des sociétés Rohm and Haas, Clariant, ou Tok, pour réaliser des réseaux de lignes ou de trous dont les périodes vont de 200 nm à 600 nm.

Après développement de la résine, la couche de diélectrique est gravée jusqu'au niveau de la couche conductrice par gravure plasma ou humide.

Puis la résine restante est retirée (« strippée ») pour ne laisser que la couche diélectrique structurée sur la couche conductrice.

La croissance par électrochimie des structures dans les cavités ainsi formées est réalisée.

Les motifs réalisés auront une hauteur légèrement supérieure à la hauteur des structures réalisées dans la couche diélectrique afin de créer une topographie vis-à-vis de la surface de diélectrique.

On dépose ensuite les couches « OLED » sur le substrat nanostructuré obtenu.

### RÉFÉRENCES

[1] W.L. Barnes, Journal of Lightwave Technology, Vol. 17, No. 11 (1999), 2170-2182.
[2] Dawn K. Gifford and Dennis G. Hall, Applied Physics Letters, Vol. 81, No. 23 (2002), 4315-4317.
[3] Dawn K. Gifford and Dennis G. Hall, Applied Phys. Letters, Vol. 80, No. 20 (2002), 3679-3681.
[4] Kuniaki Ishihara et al., Applied Physics Letters 90, 111114 (2007).
[5] Brevet US-B1-6,670,772.
[6] Demande de brevet US-A1-2005/0088084.
[7] Demande US-A1-2001/0038102.
[8] E. Budevski, G. Staikov, et W.J. Lorenz, "Electrochemical Phase Formation and Growth", VCH, Weinheim (1996).
[9] M. Paunovic, M. Electrochemical Deposition, (2006).
[10] D. Stoychev, A. Papoutsis, A. Kelaidopoulou, G. Kokkinidis, A. Milchev, "Electrodeposition of platinum on metallic and non metallic substrates-selection of experimental conditions", Materials Chemistry and Physics 72 (2001), 360--365.
[11] S.A.G. Evans, J. G. Terry, N.O.V. Plank, A.J. Walton, L.M. Keane, C.J. Campbell, P. Ghazal, 1.S. Beattie, T.-J. Su, J. Crain, A.R. Mount, "Electrodeposition of platinum metal on TiN thin films", Electrochemistry Communications 7 (2005), 125-129.
[12] C.R.K. Rao, D.C. Trivedi, "Chemical and electrochemical depositions of platinum group metals and their applications", Coordination Chemistry Reviews 249 (2005) 613-631.
[13] V. O. Jovic, B.M. Jovie, M.G. Pavlovie, "Electrodeposition of Ni, Co and Ni-Co alloy powders", Electrochimica Acta 51 (2006), 5468-5477.
[14] F. Lallemand, 1. Ricq, M. Wery, P. Bercot, J. Pagetti, "The influence of organic additives on the electrodeposition of iron-group metals and binary alloy from sulphate electrolyte", Applied Surface Science 228 (2004) 326-333.
[15] J. A. Koza, M. UhIemann, A. Gebert, 1. Schultz, "The effect of a magnetic field on the pH value in front of the electrode surface during the electrodeposition of Co, Fe and CoFe alloys", Journal of Electroanalytical Chemistry 617 (2008) 194--202.
[16] E. Gornez, R. Pollina, E. Valles, "Nickel electrodeposition on different metallic substrates", Journal of Electroanalytical Chemistry 386 (1995), 45 -56.
[17] K.-M. Yin, B.-T. Lin, "Effects of boric acid on the electrodeposition of iron, nickel and iron-nickel", Surface and Coatings Technology 78 (1996), 205-210.
[18] D. Mockute, G. Bernotiene, R. Vilkaite, "Reaction mechanism of sorne benzene sulfonamide and saccharin derivatives during nickel electrodeposition in Watts-type electrolyte", Surface and Coatings Technology 160 (2002), 152-157.
[19] C.-W. Su, F.-J. He, H. Ju, Y.-B. Zhang, E.-1. Wang, "Electrodeposition of Ni, Fe and Ni-Fe alloys on a 316 stainless steel surface in a fluorborate bath", Electrochimica Acta 54 (2009), 6257-6263.
[20] S. Vandeputte, A. Hubin, J. Vereecken, "Influence of the sodium nitrate content on the rate of the electrodeposition of silver from thiosulphate solutions", Electrochimica Acta, 42 (1997), 3429-3441.
[21] G.M. de Oliveira, 1.L. Barbosa, R.1. Broggi, I.A. Carlos, "Voltammetric study of the influence of EDTA on the silver electrodeposition and morphological and structural characterization of silver films", Journal of Electroanalytical Chemistry 578 (2005), 151-158.
[22] G.M. Zarkadas, A. Stergiou, G. Papanastasiou, "Influence of citric acid on the silver electrodeposition from aqueous AgNO) solutions", Electrochimica Acta 50 (2005), 5022-5031.
[23] M. Saitou, T. Ota, A. Nakano, S.M. Asadul Hossain, "Electrodeposition of silver thin films with shiny appearances from an electrolyte comprising silver ferrocyanidethiocyanate and antimony potassium tartrate", Surface & Coatings Technology 201 (2007), 6947-6952.
[24] C. L. Aravinda, B. Burger, W. Freyland, "Nanoscale electrodeposition of Al on n-Si (111) : H from an ionic liquid", Chemical Physics Letters 434 (2007), 271-275.
[25] T. Jiang, M. J. Cholier Brym, G. Dubé, A. Lasia, G. M. Brisard, "Electrodeposition of aluminium from ionic liquids: Part I - electrodeposition and surface morphology of aluminium from aluminium chloride (AlCl3)-1-ethyl-3-methylimidazolium chloride ([EMlmCl]) ionic liquids", Surface and coatings Technology 201 (2006), 1-9.

## Revendications

1. Procédé de fabrication d'une électrode pour une diode électroluminescente organique OLED, ladite électrode comprenant une surface comprenant une première nanostructuration diélectrique et une seconde nanostructuration métallique, sur un substrat (61), dans lequel on réalise les étapes successives suivantes :
a) on dépose une couche métallique (63), sur une surface plane (62) d'un substrat (61) ;
b) on prépare sur la couche métallique (63) une couche diélectrique (65) comprenant ladite première nanostructuration diélectrique (66) qui comporte des cavités (67) qui s'étendent depuis la surface supérieure (68) de la couche diélectrique (65) jusqu'à la surface supérieure (64) de la couche métallique (63) ;
c) on remplit au moins partiellement les cavités (67) de la première nanostructuration diélectrique (66) par un métal (611), moyennant quoi, on obtient la deuxième nanostructuration métallique.

2. Procédé selon la revendication 1, dans lequel, lors de l'étape b), la couche diélectrique (63) comprenant la première nanostructuration (66) est préparée en déposant une couche en un matériau diélectrique (65) puis une couche de résine (69), sur la couche métallique (63), en procédant à la lithographie de la couche de résine (69) pour éliminer la résine dans des zones (610) correspondant aux cavités (67) à définir dans la couche diélectrique (65), en gravant la couche (65) en un matériau diélectrique pour définir les cavités (67), et en retirant la résine.

3. Procédé selon la revendication 2, dans lequel la lithographie de la couche de résine (69) est réalisée par un procédé choisi parmi la lithographie optique, la lithographie électronique, la lithographie de nanoimpression assistée par UV, et la lithographie par nanoimpression thermique.

4. Procédé selon la revendication 2 ou 3, dans lequel le matériau diélectrique est choisi parmi SiO₂, HfO₂, et tous les matériaux isolants électriquement.

5. Procédé selon l'une quelconque des revendications 2 à 4, dans lequel la résine est choisie parmi les résines thermoplastiques et les résines thermodurcissables telles que les poly(styrène)s (PS), les poly(méthacrylate de méthyle)s (PMMA)s, les polyesters insaturés, les résines époxydes, les résines phénoliques, les polyimides, les polyamides, les polycarbonates, les polyoléfines tels que les polypropylènes, le POSS ou « polyhedral oligomeric silsesquioxane » et les mélanges de celles-ci.

6. Procédé selon la revendication 1, dans lequel, lors de l'étape b), la couche diélectrique (65) comprenant la première nanostructuration (66) est préparée en déposant une couche en une résine diélectrique, ou une couche en une résine ou en un matériau, ladite résine ou ledit matériau étant susceptible d'être transformé(e) en un matériau diélectrique, sur la couche métallique, en procédant à la lithographie de la couche en une résine ou en un matériau susceptible d'être transformé(e) en un matériau diélectrique pour y définir les cavités, et en transformant la résine ou le matériau susceptible d'être transformé(e) en un matériau diélectrique, en un matériau diélectrique, par un traitement thermique.

7. Procédé selon la revendication 6, dans lequel la couche diélectrique est en un matériau diélectrique choisi parmi les matériaux appelés « spin on glass » ou « verres centrifugés ».

8. Procédé selon l'une quelconque des revendications 6 et 7, dans lequel la lithographie de la couche en une résine ou en un matériau susceptible d'être transformé(e) en un matériau diélectrique est réalisée par un procédé choisi parmi la lithographie optique, la lithographie électronique, la lithographie de nanoimpression assistée par UV, et la lithographie par nanoimpression thermique.

9. Procédé selon l'une quelconque des revendications précédentes, dans lequel le substrat (61) est en un matériau choisi parmi le verre, les céramiques transparentes, et les plastiques transparents.

10. Procédé selon l'une quelconque des revendications précédentes, dans lequel la couche métallique (63) est en un métal choisi parmi le platine, le cobalt, le nickel, le fer, l'argent, l'aluminium, l'iridium, l'or, le molybdène, le palladium ; et leurs alliages.

11. Procédé selon l'une quelconque des revendications précédentes, dans lequel l'étape c) est réalisée par un procédé électrochimique choisi parmi les procédés d électro-déposition à potentiel ou à courant imposé et les procédés d'électro-réduction sans courant appelés procédés « electroless ».

12. Procédé selon l'une quelconque des revendications précédentes, dans lequel on remplit les cavités (67) de la première nanostructuration (66) de la couche diélectrique (65) par un métal (611), au moins jusqu'à la surface supérieure (68) de la couche diélectrique (65).

13. Procédé selon la revendication 12, dans lequel on remplit les cavités (67) de la première nanostructuration (66) de la couche diélectrique (65) par un métal (611), au-delà de la surface supérieure (68) de la couche diélectrique (65).

14. Procédé selon la revendication 13, dans lequel le métal (611)qui dépasse au-delà de la surface supérieure (68) de la couche diélectrique (65) forme des motifs (613) en relief d'une hauteur de 1 à 100 nm par rapport au niveau de la surface supérieure (68) de la couche diélectrique (65).

15. Procédé selon l'une quelconque des revendications précédentes, dans lequel la première nanostructuration diélectrique (66) est constituée par un réseau périodique, tel qu'un réseau à une dimension ou un réseau à deux dimensions.

16. Procédé selon la revendication 15, dans lequel la première nanostructuration (66) est un réseau de lignes avec des motifs périodiques d'une période P1 de préférence de 100 nm à 1 µm et d'une hauteur h1 de préférence de 5 nm à 100 nm.

17. Procédé selon la revendication 16, dans lequel les lignes de la première nanostructuration (66) ont une largeur de 50 nm à 550 nm.

18. Procédé selon la revendication 15, dans lequel la première nanostructuration (66) est un réseau de plots.

19. Procédé selon la revendication 16, dans lequel la seconde nanostructuration est un réseau de lignes avec des motifs périodiques d'une période P2 de préférence de 100 nm à 1 µm, de préférence encore de 200 nm à 600 nm, et d'une hauteur h2 de préférence de 5 nm à 100 nm.

20. Procédé selon la revendication 19, dans lequel les lignes de la seconde nanostructuration ont une largeur de 50 nm à 550 nm.

21. Procédé de fabrication d'une diode électroluminescente organique OLED comprenant au moins une étape de fabrication d'une électrode comprenant une surface comprenant une première nanostructuration diélectrique et une seconde nanostructuration métallique, sur un substrat (61), dans lequel ladite étape est réalisée par le procédé selon l'une quelconque des revendications 1 à 20.

22. Procédé selon la revendication 21, dans lequel on fabrique une première électrode comprenant une surface comprenant une première nanostructuration diélectrique et une seconde nanostructuration métallique, sur un substrat (61), par le procédé selon l'une quelconque des revendications 1 à 20 puis on dépose successivement sur la surface nanostructurée de la première électrode une ou plusieurs couche(s) organique(s) émettrice(s) conforme(s) à la surface nanostructurée de la première électrode, et une couche de seconde électrode conforme à la surface nanostructurée de la première électrode.

23. Procédé selon la revendication 22, dans lequel la première électrode est une anode et la seconde électrode est une cathode (614).

24. Procédé selon l'une quelconque des revendications 22 et 23, dans lequel on dépose en outre sur le substrat (61) une ou plusieurs autre (s) couche(s) conforme(s) à la surface nanostructurée de la première électrode, choisie(s) parmi une couche d'injection de trous, une couche de transport de trous, une couche d'injection d'électrons, une couche de transport d'électrons, une couche de blocage de trous, une couche de blocage d'électrons, une couche de transistors à couches minces (« TFT »), deux ou plus parmi cette ou ces autre(s) couche(s) , la ou les couche(s) organique(s) émettrice (s), la couche de première électrode et la couche de seconde électrode pouvant être confondues.
